(19) Europäisches Patentamt
European Patent Office
Office européen des brevets

(11) **EP 2 612 936 B1**

(12) **EUROPEAN PATENT SPECIFICATION**

(45) Date of publication and mention
of the grant of the patent:
**27.04.2016  Bulletin 2016/17**

(51) Int Cl.:
***C22C 19/05*** [(2006.01)]   ***F01D 5/00*** [(2006.01)]

(21) Application number: **12174283.7**

(22) Date of filing: **29.06.2012**

(54) **Rhenium-free single crystal superalloy for turbine blades and vane applications**

Rheniumfreie Einzelkristall-Superlegierung für Turbinenschaufeln und Schaufelanwendungen

Superalliage monocristallin exempt de rhénium pour aubes de turbine et des applications d'aubes

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.11.2011   US 201113298879**

(43) Date of publication of application:
**10.07.2013   Bulletin 2013/28**

(73) Proprietor: **CANNON-MUSKEGON
CORPORATION
Muskegon, Michigan 49441 (US)**

(72) Inventors:
• **Harris, Kenneth
Spring Lake, MI Michigan 49456 (US)**
• **Wahl, Jacqueline B.
Norton Shores, MI Michigan 49441 (US)**

(74) Representative: **Grünecker Patent- und
Rechtsanwälte
PartG mbB
Leopoldstraße 4
80802 München (DE)**

(56) References cited:
**EP-A1- 2 305 848**

• **HARRIS K ET AL: "DEVELOPMENT OF TWO
RHENIUM-CONTAINING SUPERALLOYS FOR
SINGLE-CRYSTAL BLADE AND
DIRECTIONALLY SOLIDIFIED VANE
APPLICATIONS IN ADVANCED TURBINE
ENGINES", JOURNAL OF MATERIALS
ENGINEERING AND PERFORMANCE, ASM
INTERNATIONAL, MATERIALS PARK, OH, US,
vol. 2, no. 4, 1 August 1993 (1993-08-01), pages
481-487, XP000394071, ISSN: 1059-9495**

**Description**

FIELD

Disclosed are single crystal nickel-base superalloys exhibiting excellent high temperature creep resistance, while being substantially free of rhenium, without deleteriously affecting other relevant characteristics.

BACKGROUND

Because of a worldwide growing demand for products that have customarily required substantial quantities of relatively scarce metal elements, both the demand and prices of rare metal elements have sharply increased. As a result, manufacturers are searching for new technologies that will reduce or eliminate the need for these metal elements.

Rhenium is an example of a truly rare metal that is important to various industries. It is recovered in very small quantities as a by-product of copper-molybdenum and copper production. In addition to its high cost, use of rhenium presents a supply chain risk of both economic and strategic consequence.

Rhenium has been widely employed in the production of nickel-base superalloys used to cast single crystal gas turbine components for jet aircraft and power generation equipment. More specifically, rhenium is used as an alloying additive in advanced single crystal superalloys for turbine blades, vanes and seal segments, because of its potent effect at slowing diffusion and thus slowing creep deformation, particularly at high temperatures (e.g., in excess of 1,000 degrees C) for sustained periods of time. High temperature creep resistance is directly related to the useful service life of gas turbine components and engine performance such as power output, fuel burn and carbon dioxide emissions.

Typical nickel-base superalloys used for single crystal castings contain from about 3% rhenium to about 7% rhenium by weight. Although rhenium has been used as only a relatively minor additive, it has been regarded as critical to single crystal nickel-base superalloys to inhibit diffusion and improve high temperature creep resistance, it adds considerable to the total cost of these alloys.

From the foregoing discussion, it is apparent that it would be extremely desirable to develop single crystal nickel-base superalloys that exhibit excellent high temperature creep resistance, while reducing or eliminating the need for rhenium additions, and while retaining other desirable properties such as good castability and phase stability.

EP-A-2305848 discloses rhenium-free nickel-base superalloys comprising preferred levels and ratios of elements so as to achieve good high temperature strength of both gamma matrix phase and gamma prime precipitates, as well as good environmental resistance.

SUMMARY

The rhenium-free single crystal nickel-base superalloys disclosed herein rely on, among other things, balancing the refractory metal elements (tantalum, tungsten and molybdenum) at a total amount of about 17% to 20% in order to achieve good creep-rupture mechanical properties along with acceptable alloy phase stability, in particular, ensuring freedom from excessive deleterious topological close-packed (TCP) phases that are rich in tungsten, molybdenum and chromium, while substantially eliminating rhenium from the alloy.

The present invention provides:

(1) A nickel-base superalloy for single crystal casting comprising:

5.60% to 5.85% aluminum by weight;
9.4% to 9.9% cobalt by weight;
5.0% to 6.0% chromium by weight;
0.08% to 0.35% hafnium by weight;
0.50% to 0.70% molybdenum by weight;
8.0% to 9.0% tantalum by weight;
0.60% to 0.90% titanium by weight;
8.5% to 9.8% tungsten by weight; and
the balance comprising nickel and minor amounts of optional elements, the total amount of optional elements being 1% or less by weight,
wherein the optional elements are controlled to maximums of 100 ppm carbon, 0.04% silicon, 0.01% manganese, 3 ppm sulfur, 30 ppm phosphorous, 30 ppm boron, 0.1% niobium, 150 ppm zirconium, 0.15% rhenium, 0.01% copper, 0.15% iron, 0.1% vanadium, 0.1% ruthenium, 0.15% platinum, 0.15% palladium, 200 ppm magnesium, 5 ppm nitrogen, 5 ppm oxygen, 2 ppm silver, 0.2 ppm bismuth, 10 ppm gallium, 25 ppm calcium, 1 ppm lead, 0.5 ppm selenium, 0.2 ppm tellurium, 0.2 ppm thallium, 10 ppm tin, 2 ppm antimony, 2 ppm arsenic, 5 ppm zinc, 2 ppm mercury, 2 ppm cadmium, 2 ppm germanium, 2 ppm gold, 2 ppm indium, 20 ppm sodium, 10 ppm potassium, 10 ppm barium, 2 ppm uranium, lanthanum and yttrium in a total amount of 5 to 80 ppm, and 2 ppm thorium.

(2) A nickel-base superalloy for single crystal casting according to item (1), said nickel-base superalloy containing a maximum amount of sulfur of 0.5 ppm, and further comprising an amount of lanthanum and yttrium that is targeted to achieve a total lanthanum and yttrium content that is from 5 ppm to 80 ppm in a single crystal casting.

(3) A nickel-base superalloy for single crystal casting according to item (1), having a density of about 8.8 gms/cc (kg/dm$^3$).

(4) A single crystal component cast from an alloy according to any one of items (1) to (3).

(5) A single crystal component according to item (4) that is a gas turbine component.

(6) A single crystal component according to item (4) that is a blade, a vane, or a seal segment for a gas turbine.

In accordance with certain embodiments in which enhanced oxidation resistance and/or coating and thermal barrier coating (TBC) life are desired, sulfur is present at a maximum amount of 0.5 ppm, and lanthanum and yttrium are added to target an amount of total lanthanum and yttrium of from 5 ppm to 80 ppm in single crystal components cast from the alloy.

In addition to achieving excellent high temperature creep resistance in a substantially rhenium-free composition, certain embodiments of the disclosed single crystal nickel-base superalloys have a desirably not excessive density that is about 8.8 gms/cc or less, such as 8.79 gms/cc (kg/dm$^3$).

<u>BRIEF DESCRIPTION OF THE DRAWINGS</u>

Figs. 1A, 1B and 1C are optical micrographs showing the fully heat treated microstructure of castings of a disclosed embodiment (LA-11753, CMSX-7, test bar #C912, fully heat treated, primary age 2050°F/4 hours).

Figs. 2A, 2B and 2C are scanning electron micrographs of the microstructure of fully heat treated castings from embodiments disclosed herein (LA-11753, CMSX-7, test bar #C912, fully heat treated, primary age 2050°F/4 hours).

Figs. 3, 4 and 5 are Larson-Miller stress-rupture graphs showing the surprisingly good creep strength and/or stress-rupture life properties of single crystal test bars and turbine blade castings made from the disclosed alloys.

Figs. 6A, 6B and 6C are optical micrographs showing the post-test phase stability of the disclosed alloys, which exhibit excellent phase stability and no TCP phases (LA-11772, CMSX-7, test bar #D912, 2050°F/15 ksi/141.6 hours, gage area).

Figs. 7A, 7B and 7C are scanning electron micrographs showing the post-test phase stability of the disclosed alloys, which exhibit excellent phase stability and no TCP phases (LA-11772, CMSX-7, test bar #D912, 2050°F/15 ksi/141.6 hours, gage area).

Figs. 8A, 8B and 8C are optical micrographs showing the post-test phase stability of the disclosed alloys, which exhibit excellent phase stability and no TCP phases (LA-11807, CMSX-7, mini-flat #53701Y-F, 2000°F/12 ksi/880.0 hours, gage area).

Figs. 9A, 9B and 9C are scanning electron micrographs showing the post-test phase stability of the disclosed alloys, which exhibit excellent phase stability and no TCP phases (LA-11807, CMSX-7, mini-flat #53701Y-F, 2000°F/12 ksi/880.0 hours, gage area).

Figs. 10A, 10B and 10C are optical micrographs showing the post-test phase stability of the disclosed alloys, which exhibit excellent phase stability and no TCP phases (LA-11772, CMSX-7, test bar #B913, 1800°F/36 ksi/151.1 hours, gage area).

Figs. 11A, 11B and 11C are scanning electron micrographs showing the post-test phase stability of the disclosed alloys, which exhibit excellent phase stability and no TCP phases (LA-11772, CMSX-7, test bar #B913, 1800°F/36 ksi/151.1 hours, gage area).

Figs. 12A, 12B and 12C are optical micrographs showing the post-test phase stability of the disclosed alloys, which exhibit excellent phase stability and no TCP phases (LA-11772, CMSX-7, test bar #A912, 1562°F/94.4 ksi/100.9 hours, gage area).

Figs. 13A, 13B and 13C are scanning electron micrographs showing the post-test phase stability of the disclosed alloys, which exhibit excellent phase stability and no TCP phases (LA-11772, CMSX-7, test bar #A912, 1562°F/94.4 ksi/100.9 hours, gage area).

Figs. 14A, 14B and 14C are optical micrographs showing the fully heat treated microstructures of CMSX-7 MOD B single crystal test bars.

Figs. 15A, 15B and 15C are scanning electron micrographs showing the fully heat treated microstructures of CMSX-7 MOD B single crystal test bars.

Fig. 16 is a drawing in cross section of a single crystal solid turbine blade cast from an alloy as disclosed herein which has the facility to machine both mini-bar and mini-flat specimens for machined-from-blade (MFB) stress-rupture testing.

Figs. 17 and 18 show the tensile properties of the alloys versus test temperature.

Figs. 19A, 19B and 19C are optical micrographs showing post test microstructures from a long term, high temperature stress-rupture test of an alloy as disclosed herein (LA-11891, CMSX-7 MOD. B, test bar #M923, 2000°F/12 ksi/1176.5 hours).

Figs. 20A, 20B and 20C are scanning electron micrographs showing post test microstructures from a long term, high temperature stress-rupture test of an alloy as disclosed herein (LA-11891, CMSX-7 MOD. B, test bar #M923, 2000°F/12 ksi/1176.5 hours).

DETAILED DESCRIPTION

The alloys disclosed herein will be referred to as "CMSX®-7" alloys. This is the designation that will be used commercially, the expression "CMSX" being a registered trademark of the Cannon-Muskegon Corporation used in connection with the sale of a family or series of nickel-base single crystal (SX) superalloys.

The alloys disclosed herein are alternatively described as being rhenium-free, or substantially free of rhenium. As used herein, these terms means that the alloys do not contain any added rhenium and/or that the amount of rhenium present in the alloy is a maximum of 0.15% by weight.

Unless otherwise indicated, all percentages are by weight, and all amounts in parts per million (ppm) refer to parts per million by weight based on the total weight of the alloy composition.

Single crystal superalloys and castings have been developed to exhibit an array of outstanding properties including high temperature creep resistance, long fatigue life, oxidation and corrosion resistance, solid solution strengthening, with desired casting properties and low rejection rates, and phase stability, among others. While it is possible to optimize a single additive alloying elements for a particular property, the effects on other properties are often extremely unpredictable. Generally, the relationships among the various properties and various elemental components are extremely complex and unpredictable such that it is surprising when a substantial change can be made to the composition without deleteriously affecting at least certain essential properties.

With the embodiments disclosed herein, refractory metal elements (tantalum, tungsten and molybdenum) were maintained at a total amount of from about 17% to about 20% by weight, while balancing the amounts of the refractory elements to achieve good creep-rupture mechanical properties along with acceptable alloy phase stability (freedom from excessive deleterious topological close-packed (TCP) phase - normally tungsten, molybdenum and chromium rich in this type of alloy). Chromium and cobalt were also adjusted to ensure the required phase stability. The high amount of tantalum (approximately 8%) was selected to provide excellent single crystal castability, such as freedom from "freckling" defects. The amount of titanium (approximately 0.8%) and tantalum (approximately 0.8%) were adjusted to provide low negative $\gamma/\gamma'$ mismatch for high temperature creep strength and acceptable room temperature density (e.g., about 8.8 gms/cc, such as 8.79 gms/cc). Aluminum, titanium and tantalum were adjusted to attain a suitable $\gamma'$ volume fraction (Vf), while the combination of aluminum, molybdenum, tantalum and titanium were selected to provide good high temperature oxidation resistance properties. The amount of hafnium addition was selected for coating life attainment at high temperatures.

Typical chemistry for the alloys disclosed and claimed herein are listed in Table 1. However, there are certain minor variations. In order to achieve enhanced oxidation resistance and/or enhanced thermal barrier coating life, it is desirable to add lanthanum and/or yttrium in amounts such that the total of lanthanum and yttrium is targeted to provide from about 5 to 80 ppm in the single crystal castings made from the alloys.

The invention will be described with respect to certain illustrative, non-limiting embodiments that will facilitate a better understanding.

A 400 lb 100% virgin initial heat of CMSX®-7 alloy was melted in January 2011 in the CM V-5 Consarc VIM furnace using aim chemistry to CM KH 01/03/11 (CM CRMP #81-1700 Issue 1). The heat (5V0424) chemistry is shown in Table 2.

Two molds (#s 912 and 913) of SX NNS DL-10 test bars were cast to CMSX-4® casting parameters by Rolls-Royce Corporation (SCFO). DL-10 test bar yield at 23 fully acceptable out of a total 24 cast was excellent. A mold (#53701) of solid HP2 turbine blades were also SX cast by SCFO using CMSX-4® casting parameters with typical casting yields for this production component.

These DL-10 test bars and turbine blades were solutioned/homogenized + double aged heat treated at CM as follows - based on solutioning/homogenization studies on CMSX®-7 test bars.

## Solution + Homogenization

- 2 hrs / 2340°F (1282°C) + 2 hrs / 2360°F (1293°C)
  + 4 hrs / 2380°F (1304°C) + 4 hrs / 2390°F (1310°C)
  + 12 hrs / 2400°F (1316°C) AC - ramping up at 1 °F / min. between steps
- Double Age
  4 hrs / 2050°F (1121°C) AC + 20 hrs / 1600°F (871°C) AC

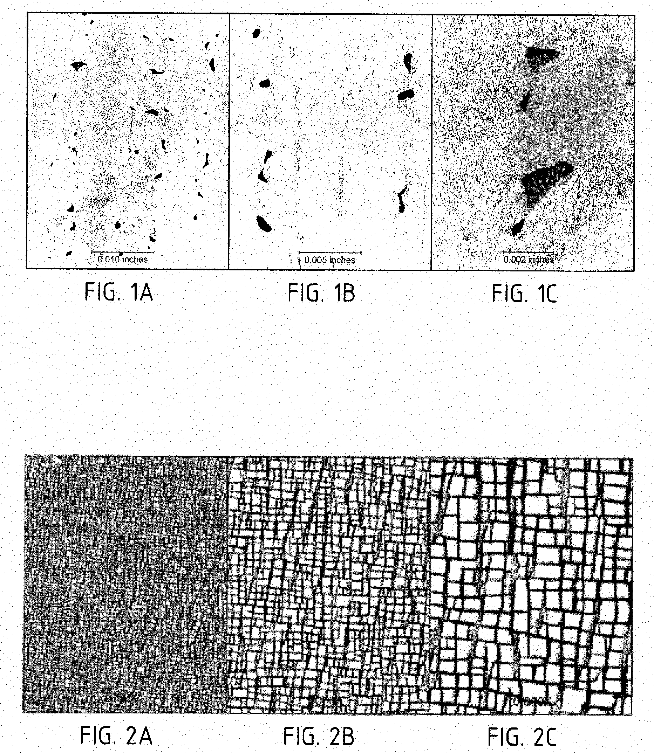

Acceptable microstructure attainment is evident in Figs 1-2 - complete γ' solutioning, some remnant γ/γ' eutectic, no incipient melting and approximately 0.5 μm average cubic, aligned γ', indicating appropriate γ/γ' mis-match and γ/γ' inter-facial chemistry, following the 4 hr / 2050°F (1121 °C) high temperature age.

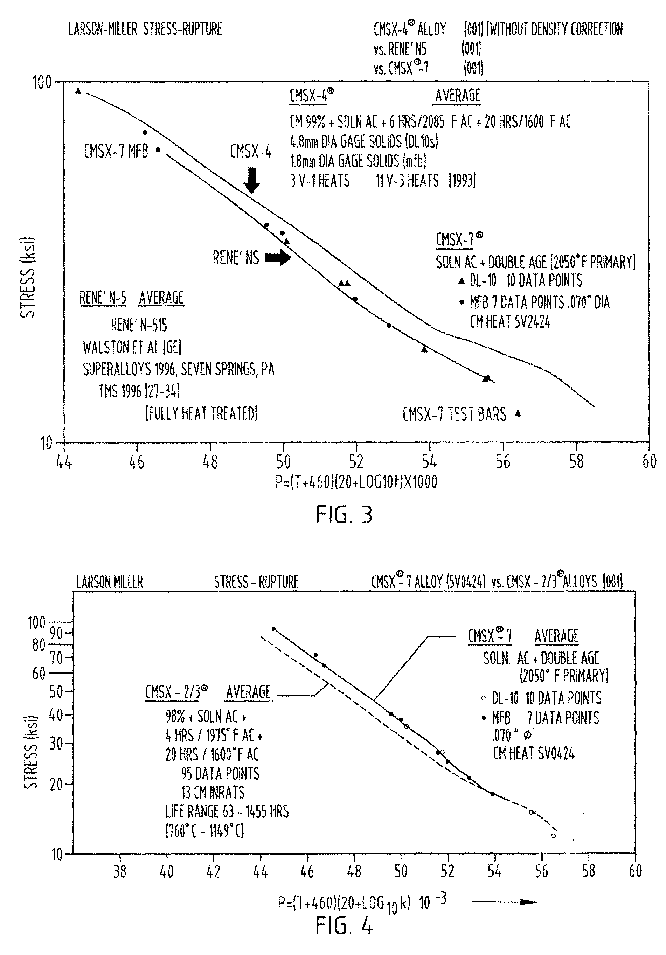

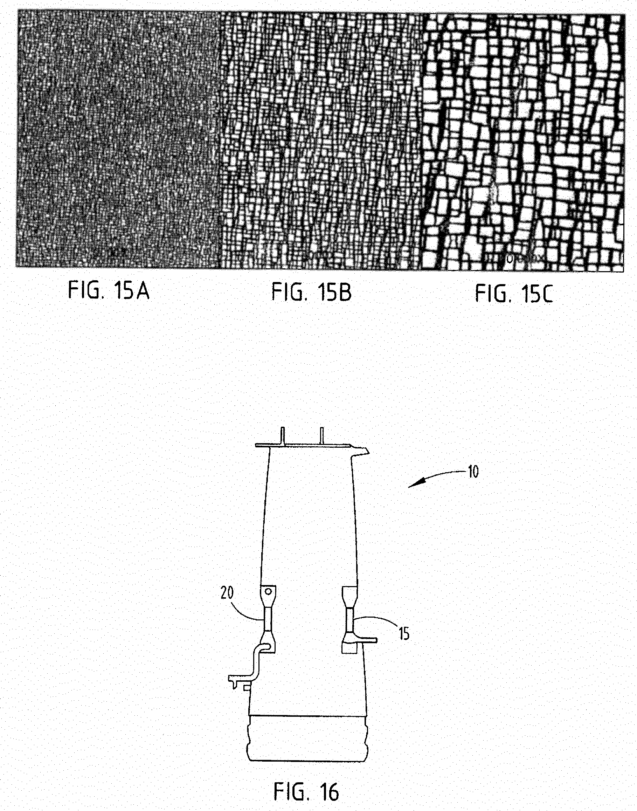

Creep - and stress-rupture specimens were low stress ground and tested by Joliet Metallurgical Labs, with the results to date shown in Table 3 and Table 4. Larson-Miller stress-rupture graphs (Figs. 3, 4 & 5) show CMSX®-7 has superior and surprisingly good creep strength / stress-rupture life properties, including machined-from-blade (MFB) 0.070" Ø mini-bar results, compared to CMSX-2/3® alloy (zero Re) up to approximately 1900°F (1038°C), with similar properties at 2050°F (1121°C). All these properties are surprisingly similar to Rene' N-5 (3% Re) and Rene' N-515 (1.5% Re) alloys (Published GE data) [JOM 62 No 1, pgs 55-57 Jan 2010]. MFB stress-rupture testing was performed on single crystal solid turbine blades 10 (Fig. 16) cast from alloys as disclosed herein which have facility to machine mini-bars 15 and mini-flat specimens 20.

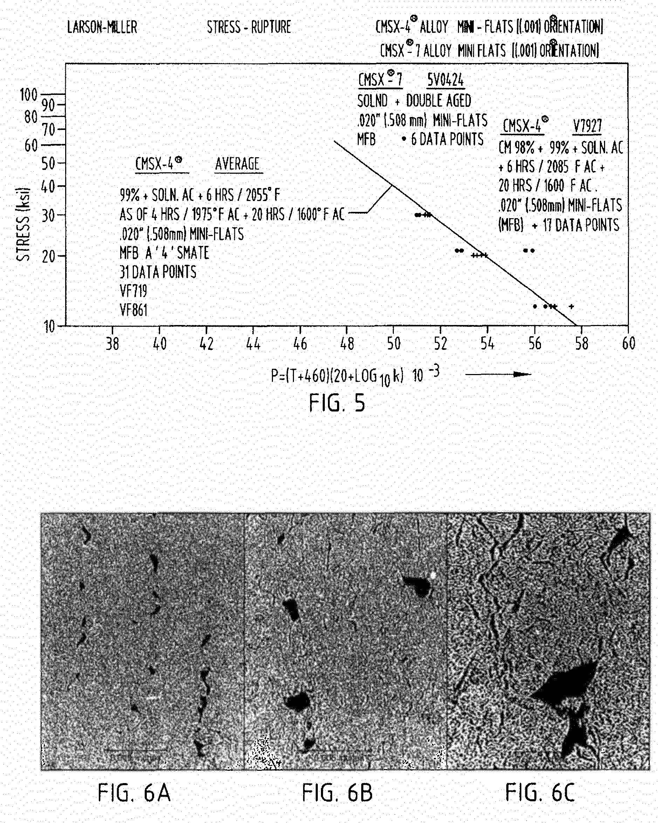

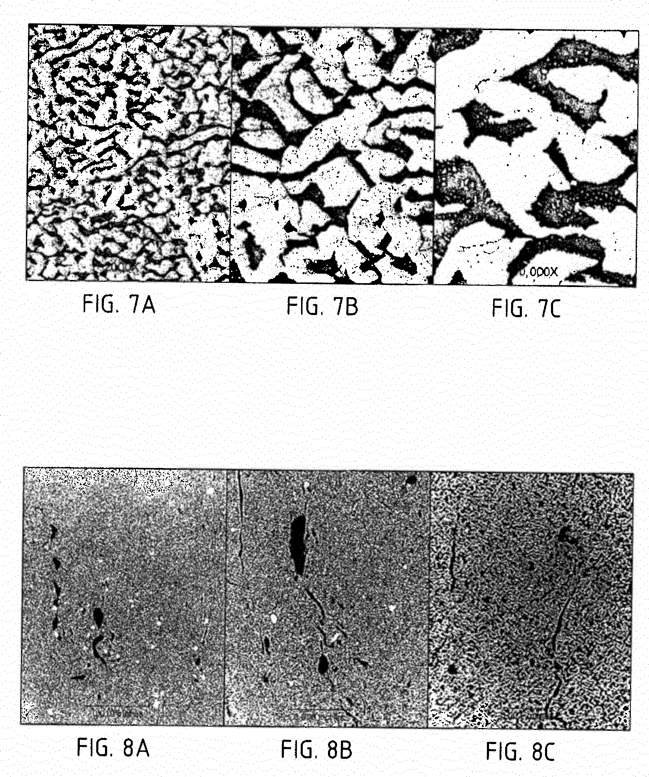

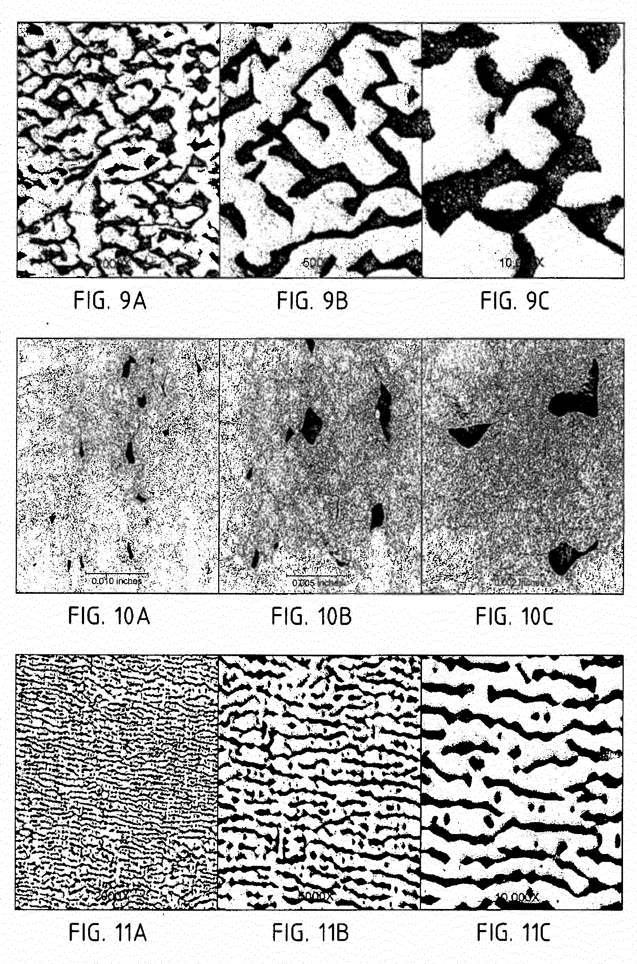

Phase stability is surprisingly good with absolutely no TCP phases apparent in the post-test creep/stress rupture bars examined to date (Figs. 6-13 inclusive).

Burner rig dynamic, cyclic oxidation and hot corrosion (sulfidation) testing is currently scheduled at a major turbine engine company. The MFB 0.020" thick gage mini-flat results at 12 ksi/2000°F (Table 4, Fig. 5) indicate good bare high temperature oxidation resistance for this alloy.

CMSX-7 Tensile Properties

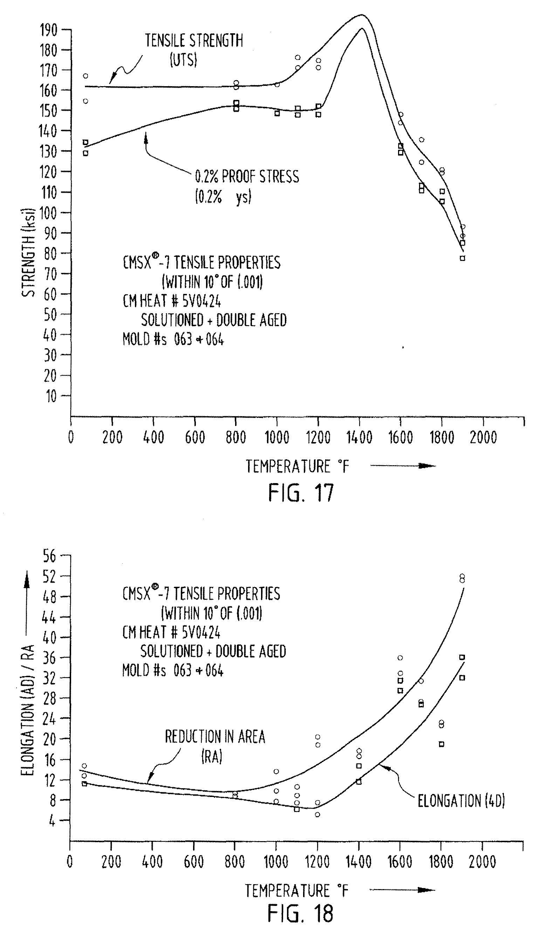

The alloy shows very high tensile strength (up to 200 ksi (1379 MPa) UTS at 1400°F (760°C)) and 0.2% proof stress (up 191 ksi (1318 MPa) at the same temperature and good ductility (Table 5, Figs 17 & 18). The exceptionally high UTS and 0.2% PS at 1400°F (760°C) indicates strain hardening at this temperature, possibly due to further secondary or tertiary γ' precipitation in the γ channels at this temperature impeding dislocation movement - the ductility at this maximum strength level is in the range of 13% elongation (4D) and 17% reduction in area (RA).

Table 1

CHEMISTRY (WT% / ppm) SPECIFICATIONS CMSX®-7 ALLOY

• Aero engine Applications

| | | | |
|---|---|---|---|
| C | 100 ppm | Ti | .60-.90 |
| Si | .04% Max | W | 8.5 - 9.8 |
| Mn | .01% Max | Zr | 150 ppm Max |
| S | 3 ppm Max | Re | .15% Max |
| A1 | 5.60 - 5.85 | Cu | .01% Max |
| B | 30 ppm Max | Fe | .15% Max |
| Cb (Nb) | .10% Max | V | .10% Max |
| Co | 9.4 - 9.9 | Ru | .10% Max |
| Cr | 5.0-6.0 | Pt | .15% Max |
| Hf | .08 - .35 | Pd | .15% Max |
| Mo | .50 - .70 | Mg | 200 ppm Max |
| Ni | Balance | [N] | 5 ppm Max |
| Ta | 8.0-9.0 | [O] | 5 ppm Max |

• Enhanced oxidation resistance/coating and thermal barrier coating (TBC) life

S 0.5 ppm max

La + Y 5 - 80 ppm (In the SX castings).

(continued)

TRACE ELEMENT CONTROLS - ALL APPLICATIONS

| | | | |
|---|---|---|---|
| Ag | 2 ppm Max | Hg | 2 ppm Max |
| Bi | .2 ppm Max | Cd | 2 ppm Max |
| Ga | 10 ppm Max | Ge | 2 ppm Max |
| Ca | 25 ppm Max | Au | 2 ppm Max |
| Pb | 1 ppm Max | In | 2 ppm Max |
| Se | .5 ppm Max | Na | 20 ppm Max |
| Te | .2 ppm Max | K | 10 ppm Max |
| Tl | .2 ppm Max | Ba | 10 ppm Max |
| Sn | 10 ppm Max | P | 30 ppm Max |
| Sb | 2 ppm Max | U | 2 ppm Max |
| As | 2 ppm Max | Th | 2 ppm Max |
| Zn | 5 ppm Max | | |

Density: 8.79 gms/cc.

Table 2

**HEAT #5V0424 CMSX®-7 - 100% VIRGIN CHEMISTRY (WT ppm / %)**

| | | | |
|---|---|---|---|
| C | 17 ppm | Re | < .05 |
| Si | < .02 | Cu | < .001 |
| Mn | < .001 | Fe | .012 |
| S | 1 ppm | V | < .005 |
| Al | 5.80 | Ru | < .01 |
| B | < 20 ppm | Pt | < .001 |
| Cb (Nb) | <.05 | Pd | < .001 |
| Co | 9.7 | Mg | < 100 ppm |
| Cr | 5.8 | [N] | 3 ppm |
| Hf | .29 | [O] | 2 ppm |
| Mo | .60 | Y | < .001 |
| Ni | Balance | La | < .001 |
| Ta | 8.6 | Ce | < .002 |
| Ti | .82 | | |
| W | 9.0 | | |
| Zr | < 25 ppm | | |
| | | Ag | < .4 ppm |
| | | Bi | < .2 ppm |
| | | Ga | < 10 ppm |
| | | Ca | < 25 ppm |
| | | Pb | < .5 ppm |
| | | Se | < .5 ppm |
| | | Te | < .2 ppm |
| | | Tl | < .2 ppm |
| | | Sn | < 2 ppm |
| | | Sb | < 1 ppm |
| | | As | < 1 ppm |
| | | Zn | < 1 ppm |
| | | Hg | < 2 ppm |
| | | Cd | < .2 ppm |
| | | Ge | < 1 ppm |
| | | Au | < .5 ppm |

(continued)

**HEAT #5V0424 CMSX®-7 - 100% VIRGIN CHEMISTRY (WT ppm / %)**

| | |
|---|---|
| In | < .2 ppm |
| Na | < 10 ppm |
| K | < 5 ppm |
| Ba | < 10 ppm |
| P | 6 ppm |
| U | < .5 ppm |
| Th | < 1 ppm |

Table 3

**CMSX-7 Heat 5V0424**

Molds 912/913 (DL-10s) - RR SCFO [Indy] - LA 11753 (Joliet 8935/CM-354)

K912/L912 - LA 11773 (Joliet 8979/CM-356)

Fully Heat Treated - Solution + double age - 2050°F primary age

| Creep-Rupture Test Condition | ID | Rupture Life, hrs | % Elong | % RA | Time to 1% Creep | Time to 2% Creep |
|---|---|---|---|---|---|---|
| 1562°F/94.4 ksi | A912 | 100.9 | 22.4 | 28.8 | 5.9 | 19.8 |
| [850°C/651 MPa] | A913 | 100.8 | 18.4 | 27.3 | 7.0 | 22.3 |
| 1800°F/36.0 ksi | B912 | 147.2 | 41.8 | 14.7 | 58.4 | 71.1 |
| [982°C/248 MPa] | B913 | 151.1 | 44.6 | 49.6 | 58.4 | 70.4 |
| 1922°F/27.6 ksi | C912 | 53.9 | 43.6 | 46.9 | 19.3 | 24.4 |
| [1050°C/190 MPa] | C913 | 46.0 | 37.1 | 49.7 | 15.8 | 20.6 |
| 1950°F/18.0 ksi [1066°C/124 MPa] | L912 | 224.9 | 37.0 | 62.3 | 92.4 | 112.3 |
| 2000°F/12.0 ksi [1093°C/83 MPa] | K912 | 860.3 | 22.1 | 54.5 | 538.1 | 607.2 |
| **Stress-Rupture Test Condition** | **ID** | **Rupture Life, hrs** | **% Elong** | **% RA** | | |
| 2050°F/15.0 ksi | D912 | 141.6 | 32.4 | 52.6 | | |
| [1121°C/103 MPa] | E912 | 130.2 | 31.4 | 55.0 | | |

Machining and Testing Source: Joliet Metallurgical Laboratory

Table 4

**CMSX®-7 Heat 5V0424**

Mold 53701 - HP2 Solid Turbine Blades RR SCFO [Indy] - LA 11773 (Joliet 8980/CM- 357)

Fully Heat Treated - Solution + double age - 2050°F primary age

**MFB (LLE)**

**Stress-Rupture**

**Mini Bars [0.070" Ø Gage, shown in Fig. 16]**

| Test Condition | ID | Rupture Life, hrs | % Elong | % RA |
|---|---|---|---|---|
| 1562°F/72.5 ksi [850°C/500 MPa] | 53701 U-B | 783.4 | 33.3 | 28.9 |
| 1600°F/65.0 ksi [871°C/448 MPa] | 53701V-B | 437.9 | 32.8 | 33.7 |
| 1800°F/40.0 ksi [982°C/276 MPa] | 53701S-B | 84.1 | 39.5 | 47.8 |
| 1850°F/38.0 ksi [1010°C/262 MPa] | 53701T-B | 43.2 | 38.5 | 37.8 |
| 1900°F/25.0 ksi [1038°C/172 MPa] | 53701Y-B | 105.8 | 36.1 | 28.5 |
| 1904°F/21.0 ksi [1040°C/145 MPa] | 53701Z-B | 238.4 | 59.3 | 44.5 |

(continued)

**MFB (LTE)**

**Mini Flats [0.020" Thick Gage, shown in Fig. 16]**

| Test Condition | ID | Rupture Life, hrs | % Elong |
|---|---|---|---|
| 1800°F/30.0 ksi [982°C/207 MPa] | 53701S-F | 387.3 | 42.7 |
| | 53701T-F | 344.4 | 35.0 |
| 1904°F/21.0 ksi [1040°C/145 MPa] | 53701U-F | 219.8 | 38.1 |
| | 53701V-F | 189.5 | 33.3 |
| 2000°F/12.0 ksi [1093°C/83 MPa] | 53701Y-F | 880.0 | 32.4 |
| | 53701Z-F | 578.8 | 13.9 |

Machining and Testing Source: Joliet Metallurgical Laboratory

Table 5

**CMSX-7 - Heat 5V0424**

Molds 063/064 - RR SCFO [Indy] - LA 11753 (Joliet 8935/CM-354)

Fully Heat Treated - Solution + Double Age - 2050°F Primary Age

| TENSILE TEST RESULTS | | | | | |
|---|---|---|---|---|---|
| **Test Temperature** | **ID** | **0.2% PS** | **UTS** | **% Elong (4D)** | **% RA** |
| | | (ksi) | (ksi) | | |
| 70°F (21°C) | A063 | 135.1 | 154.6 | 11.4 | 13.1 |
| | A064 | 129.1 | 168.1 | 11.3 | 15.3 |
| 800°F (430°C) | B063 | 154.2 | 163.8 | 9.1 | 9.5 |
| | B064 | 151.6 | 162.2 | 9.0 | 9.8 |
| 1000°F (538°C) | K063 | 149.7 | 163.3 | 8.0 | 10.0 |
| | K064 | 148.6 | 163.2 | 8.0 | 13.9 |
| 1100°F (593°C) | L063 | 149.6 | 172.0 | 7.7 | 10.7 |
| | L064 | 151.9 | 177.1 | 6.5 | 9.3 |
| 1200°F (649°C) | M063 | 153.8 | 175.5 | 7.8 | 19.2 |
| | M064 | 149.0 | 172.0 | 5.4 | 20.4 |
| 1400°F (760°C) | N063 | 190.4 | 198.9 | 14.9 | 16.8 |
| | N064 | 191.7 | 199.7 | 12.0 | 17.9 |
| 1600°F (871°C) | P063 | 131.3 | 148.4 | 31.9 | 33.2 |
| | P064 | 133.9 | 145.3 | 29.8 | 36.1 |
| 1700°F (927°C) | R063 | 112.8 | 136.9 | 27.5 | 27.7 |
| | R064 | 115.0 | 126.4 | 27.0 | 31.7 |
| 1800°F (982°C) | Y063 | 112.4 | 123.3 | 19.5 | 23.0 |
| | W064 | 106.9 | 120.3 | 23.6 | 23.8 |
| 1900°F (1038°C) | Z063 | 88.3 | 94.6 | 32.5 | 52.2 |
| | X064 | 78.9 | 90.2 | 36.6 | 51.4 |
| | | [100 ksi = 690 Mpa] | | | |

Machining & Testing Source: Joliet Metallurgical Laboratory

Table 6

**HEAT #5V0459 CMSX®-7 Mod B -100% VIRGIN CHEMISTRY (WT ppm/%)**

| | | | |
|---|---|---|---|
| C | 9 ppm | Re | < .05 |
| Si | <.02 | Cu | < .001 |
| Mn | < .001 | Fe | .015 |
| S | 1 ppm | V | < .005 |

(continued)

**HEAT #5V0459 CMSX®-7 Mod B -100% VIRGIN CHEMISTRY (WT ppm/%)**

| | | | |
|---|---|---|---|
| Al | 5.780 | Ru | < .01 |
| B | < 25 ppm | Pt | < .001 |
| Cb (Nb) | <.05 | Pd | < .001 |
| Co | 9.7 | Mg | < 100 ppm |
| Cr | 5.6 | [N] | 1 ppm |
| Hf | .30 | [O] | 1 ppm |
| Mo | .59 | Y | < .001 |
| Ni | Balance | La | < .001 |
| Ta | 8.4 | Ce | < .002 |
| Ti | .70 | | |
| W | 9.3 | | |
| Zr | < 25 ppm | | |

| | |
|---|---|
| Ag | < .4 ppm |
| Bi | < .2 ppm |
| Ga | < 10 ppm |
| Ca | < 25 ppm |
| Pb | < .5 ppm |
| Se | < .5 ppm |
| Te | < .2 ppm |
| Tl | < .2 ppm |
| Sn | < 2 ppm |
| Sb | < 1 ppm |
| As | < 1 ppm |
| Zn | < 1 ppm |
| Hg | < 2 ppm |
| Cd | < .2 ppm |
| Ge | < 1 ppm |
| Au | < .5 ppm |
| In | < .2 ppm |
| Na | < 10 ppm |
| K | < 5 ppm |
| P | 8 ppm |
| U | < .5 ppm |
| Th | < 1 ppm |

Table 7

**CMSX-7 MOD B - Heat 5V0459**

Molds 923/924 - (DL- 10s) - RR SCFO [Indy] - LA11834 (Joliet 9156/CM-368) [DL-10s]

Fully Heat Treated - Solution + double age

| Creep-Rupture Test Condition | ID | Rupture Life, hrs | % Elong | % RA | 1% Creep | 2% Creep |
|---|---|---|---|---|---|---|
| 1562°F/72.5 ksi | A923 | 972.7 | 19.6 | 25.2 | 298.3 | 463.7 |
| [850°C/500 MPa] | H923 | 861.8 | 20.6 | 27.6 | 275.7 | 411.2 |
| 1600°F/65.0 ksi | B923 | 667.4 | 21.8 | 26.5 | 224.6 | 323.0 |
| [871°C/448 MPa] | R924 | 670.4 | 19.8 | 31.3 | 262.8 | 363.8 |
| 1800°F/36.0 ksi | C923 | 139.2 | 37.9 | 45.6 | 56.2 | 68.0 |
| [982°C/248 MPa] | N924 | 151.5 | 31.6 | 38.0 | 64.6 | 77.2 |
| 1800°F/40.0 ksi | D923 | 97.4 | 34.8 | 41.5 | 39.4 | 48.0 |

(continued)

| Creep-Rupture Test Condition | ID | Rupture Life, hrs | % Elong | % RA | 1% Creep | 2% Creep |
|---|---|---|---|---|---|---|
| [982°C/276 MPa] | M24 | 106.3 | 28.8 | 33.7 | 45.3 | 55.2 |
| 1850°F/38.0 ksi | E923 | 51.7 | 34.3 | 35.2 | 21.1 | 25.6 |
| [1010°C/262 MPa] | L924 | 54.1 | 36.5 | 36.6 | 21.2 | 26.0 |
| 1900°F/25.0 ksi | J923 | 103.0 | 25.1 | 43.5 | 39.5 | 49.3 |
| [1038°C/172 MPa] | H924 | 111.2 | 27.6 | 40.2 | 38.6 | 51.1 |
| 1904°F/21.0 ksi | K923 | 240.2 | 31.0 | 47.1 | 90.6 | 112.9 |
| [1040°C/145 MPa] | E924 | 245.7 | 43.4 | 46.7 | 86.5 | 109.1 |
| 1950°F/18.0 ksi | L923 | 260.5 | 27.4 | 37.5 | 86.0 | 112.4 |
| [1066°C/124 MPa] | D924 | 219.1 | 38.4 | 41.7 | 79.8 | 101.5 |

| Stress-Rupture Test Condition | ID | Rupture Life, hrs | % Elong | % RA |
|---|---|---|---|---|
| 2000°F/12.0 ksi | M923 | 1176.5 | 34.4 | 42.4 |
| [1093°C/83 MPa] | B924 | 960.4 | 37.4 | 42.9 |
| 2050°F/15.0 ksi | N923 | 143.7 | 20.7 | 36.5 |
| [1121 °C/103 MPa] | A924 | 135.8 | 26.3 | 38.2 |

Machining and Testing Source: Joliet Metallurgical Laboratory

A further heat (5V0459) of 100% Virgin (470 lbs) designated CMSX®-7 Mod B was melted in May 2011 in the CM V-5 Consarc VIM furnace using aim chemistry to CM KH 04/13/11 (CM CRMP #81-1703 Issue 1). The heat (5V0459) chemistry is shown in Table 6.

Two molds (#s 923 & 924) of SX NNS DL-10 test bars were cast to CMSX-4® casting parameters by Rolls-Royce Corporation (SCFO). DL-10 test bar yield at 22 fully acceptable out of a total 24 cast was excellent.

These DL-10 test bars were solutioned/homogenized + double aged heat treated at Cannon-Muskegon Corporation as follows - based on solutioning/ homogenization studies on CMSX®-7 Mod B test bars.

Solutioning and Homogenization

- 2 hrs / 2360°F (1293°C) + 2 hrs /2370°F (1299°C) + 2 hrs / 2380°F (1304°C) + 12 hrs / 2390°F (1310°C) AC - ramping up at 1°F/min.
- Double Age Heat Treatment 4 hrs / 2050°F (112 °C) AC + 20 hrs / 1600°F (871 °C) AC

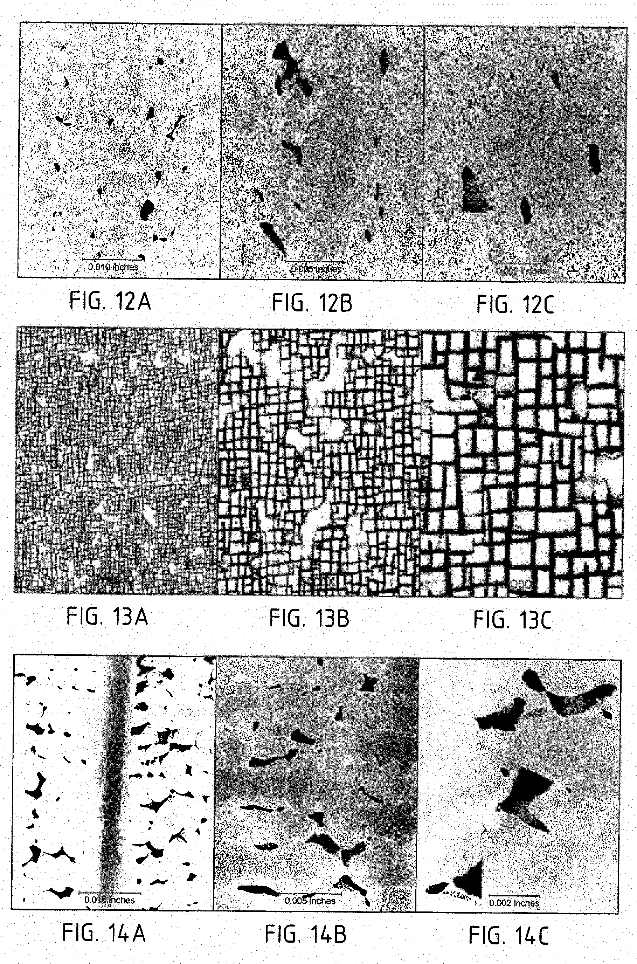

Acceptable microstructure attainment is evident Figs. 14 & 15, almost complete $\gamma'$ solutioning, remnant $\gamma/\gamma'$ eutectic, no incipient melting and approximately 0.45 $\mu$m average cubic aligned $\gamma'$, indicating appropriate $\gamma/\gamma'$ mismatch and $\gamma/\gamma'$ inter-facial chemistry, following the 4 hr / 2050°F (1121 °C) high temperature age.

The creep-rupture properties of CMSX®-7 Mod B are very similar to that of CMSX®-7, with no apparent advantage (Table 7).

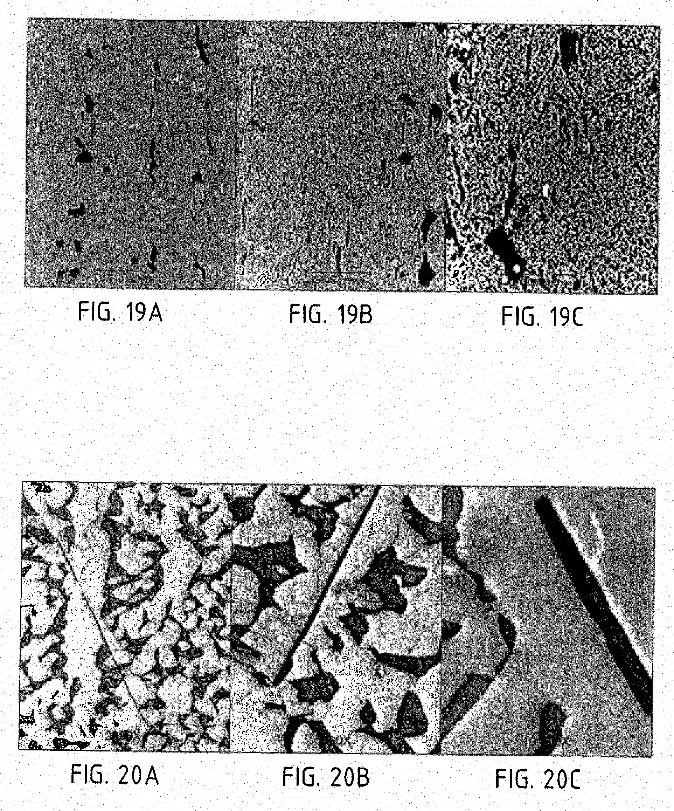

Post-test microstructures from a longer term, high temperature stress-rupture test [2000°F/12 ksi (1093°C/83 MPa)/1176.5 hours] are shown (Figs. 19A-19C) to exhibit good phase stability, with negligible TCP phase ("needles") apparent, combined with good stress-rupture life and rupture ductility (34% elongation (4D)) and 42% RA (Figs. 19A-20C).

**Claims**

1. A nickel-base superalloy for single crystal casting comprising:

   5.60% to 5.85% aluminum by weight;
   9.4% to 9.9% cobalt by weight;

5.0% to 6.0% chromium by weight;

0.08% to 0.35% hafnium by weight;

0.50% to 0.70% molybdenum by weight;

8.0% to 9.0% tantalum by weight;

0.60% to 0.90% titanium by weight;

8.5% to 9.8% tungsten by weight; and

the balance comprising nickel and minor amounts of optional elements, the total amount of optional elements being 1% or less by weight,

wherein the optional elements are controlled to maximums of 100 ppm carbon, 0.04% silicon, 0.01% manganese, 3 ppm sulfur, 30 ppm phosphorous, 30 ppm boron, 0.1% niobium, 150 ppm zirconium, 0.15% rhenium, 0.01% copper, 0.15% iron, 0.1 % vanadium, 0.1 % ruthenium, 0.15% platinum, 0.15 % palladium, 200 ppm magnesium, 5 ppm nitrogen, 5 ppm oxygen, 2 ppm silver, 0.2 ppm bismuth, 10 ppm gallium, 25 ppm calcium, 1 ppm lead, 0.5 ppm selenium, 0.2 ppm tellurium, 0.2 ppm thallium, 10 ppm tin, 2 ppm antimony, 2 ppm arsenic, 5 ppm zinc, 2 ppm mercury, 2 ppm cadmium, 2 ppm germanium, 2 ppm gold, 2 ppm indium, 20 ppm sodium, 10 ppm potassium, 10 ppm barium, 2 ppm uranium, lanthanum and yttrium in a total amount of 5 to 80 ppm, and 2 ppm thorium.

2. A nickel-base superalloy for single crystal casting according to claim 1, said nickel-base superalloy containing a maximum amount of sulfur of 0.5 ppm, and further comprising an amount of lanthanum and yttrium that is targeted to achieve a total lanthanum and yttrium content that is from 5 ppm to 80 ppm in a single crystal casting.

3. A nickel-base superalloy for single crystal casting according to claim 1, having a density of about 8.8 gms/cc (kg/dm$^3$).

4. A single crystal component cast from an alloy according to any one of claims 1 to 3.

5. A single crystal component according to claim 4 that is a gas turbine component.

6. A single crystal component according to claim 4 that is a blade, a vane, or a seal segment for a gas turbine.

**Patentansprüche**

1. Nickelbasis-Superlegierung zum Einkristall-Gießen, umfassend:

5,60 % bis 5,85 % Aluminium, bezogen auf das Gewicht;

9,4 % bis 9,9 % Cobalt, bezogen auf das Gewicht;

5,0 % bis 6,0 % Chrom, bezogen auf das Gewicht;

0,08 % bis 0,35 % Hafnium, bezogen auf das Gewicht;

0,50 % bis 0,70 % Molybdän, bezogen auf das Gewicht;

8,0 % bis 9,0 % Tantal, bezogen auf das Gewicht;

0,60 % bis 0,90 % Titan, bezogen auf das Gewicht;

8,5 % bis 9,8 % Wolfram, bezogen auf das Gewicht; und

wobei der Rest Nickel und kleinere Mengen von optionalen Elementen umfasst, wobei die Gesamtmenge der optionalen Elemente 1 % oder weniger, bezogen auf das Gewicht, beträgt,

wobei die optionalen Elemente auf Höchstwerte von 100 ppm Kohlenstoff, 0,04 % Silicium, 0,01 % Mangan, 3 ppm Schwefel, 30 ppm Phosphor, 30 ppm Bor, 0,1 % Niob, 150 ppm Zirconium, 0,15 % Rhenium, 0,01 % Kupfer, 0,15 % Eisen, 0,1 % Vanadium, 0,1 % Ruthenium, 0,15% Platin, 0,15% Palladium, 200 ppm Magnesium, 5 ppm Stickstoff, 5 ppm Sauerstoff, 2 ppm Silber, 0,2 ppm Bismut, 10 ppm Gallium, 25 ppm Calcium, 1 ppm Blei, 0,5 ppm Selen, 0,2 ppm Tellur, 0,2 ppm Thallium, 10 ppm Zinn, 2 ppm Antimon, 2 ppm Arsen, 5 ppm Zink, 2 ppm Quecksilber, 2 ppm Cadmium, 2 ppm Germanium, 2 ppm Gold, 2 ppm Indium, 20 ppm Natrium, 10 ppm Kalium, 10 ppm Barium, 2 ppm Uran, Lanthan und Yttrium in einer Gesamtmenge von 5 bis 80 ppm, und 2 ppm Thorium kontrolliert werden.

2. Nickelbasis-Superlegierung zum Einkristall-Gießen gemäß Anspruch 1, wobei die Nickelbasis-Superlegierung eine Höchstmenge von Schwefel von 0,5 ppm enthält und außerdem eine Menge von Lanthan und Yttrium umfasst, die darauf abzielt, einen Gesamt-Lanthan- und Yttrium-Gehalt, der 5 ppm bis 80 ppm beträgt, in einem Einkristall-Gießen zu erreichen .

**3.** Nickelbasis-Superlegierung zum Einkristall-Gießen gemäß Anspruch 1, mit einer Dichte von ungefähr 8,8 g/cm$^3$ (kg/dm$^3$).

**4.** Einkristall-Komponente, gegossen aus einer Legierung gemäß einem der Ansprüche 1 bis 3.

**5.** Einkristall-Komponente gemäß Anspruch 4, welche eine Gasturbinenkomponente ist.

**6.** Einkristall-Komponente gemäß Anspruch 4, welche eine Turbinenschaufel, eine Leitschaufel oder ein Dichtungssegment für eine Gasturbine ist.


**Revendications**

**1.** Superalliage à base de nickel pour moulage monocristallin comprenant :

de 5,60 % à 5,85 % d'aluminium en poids ;
de 9,4 % à 9,9 % de cobalt en poids ;
de 5,0 % à 6,0 % de chrome en poids ;
de 0,08 % à 0,35 % d'hafnium en poids ;
de 0,50 % à 0,70 % de molybdène en poids ;
de 8,0 % à 9,0 % de tantale en poids ;
de 0,60 % à 0,90 % de titane en poids ;
de 8,5 % à 9,8 % de tungstène en poids ; et
le reste étant constitué de nickel et de quantités mineures d'éléments facultatifs, la quantité totale d'éléments facultatifs étant inférieure ou égale à 1 % en poids,
les éléments facultatifs étant contrôlés pour respecter les maxima suivants : 100 ppm de carbone, 0,04 % de silicium, 0,01 % de manganèse, 3 ppm de soufre, 30 ppm de phosphore, 30 ppm de bore, 0,1 % de niobium, 150 ppm de zirconium, 0,15 % de rhénium, 0,01 % de cuivre, 0,15 % de fer, 0,1 % de vanadium, 0,1 % de ruthénium, 0,15 % de platine, 0,15 % de palladium, 200 ppm de magnésium, 5 ppm d'azote, 5 ppm d'oxygène, 2 ppm d'argent, 0,2 ppm de bismuth, 10 ppm de gallium, 25 ppm de calcium, 1 ppm de plomb, 0,5 ppm de sélénium, 0,2 ppm de tellurium, 0,2 ppm de thallium, 10 ppm d'étain, 2 ppm d'antimoine, 2 ppm d'arsenic, 5 ppm de zinc, 2 ppm de mercure, 2 ppm de cadmium, 2 ppm de germanium, 2 ppm d'or, 2 ppm d'indium, 20 ppm de sodium, 10 ppm de potassium, 10 ppm de baryum, 2 ppm d'uranium, du lanthane et de l'yttrium dans une quantité totale de 5 à 80 ppm et 2 ppm de thorium.

**2.** Superalliage à base de nickel pour moulage monocristallin selon la revendication 1, ledit superalliage à base de nickel contenant une quantité maximale de soufre de 0,5 ppm, et comprenant en outre une quantité de lanthane et d'yttrium ciblée pour atteindre une teneur totale de lanthane et d'yttrium allant de 5 ppm à 80 ppm dans une coulée de monocristal.

**3.** Superalliage à base de nickel pour moulage monocristallin selon la revendication 1, ayant une masse volumique d'environ 8,8 g/cc (kg/dm$^3$).

**4.** Composant monocristallin moulé à partir d'un alliage selon l'une quelconque des revendications 1 à 3.

**5.** Composant monocristallin selon la revendication 4 qui est un composant de turbine à gaz.

**6.** Composant monocristallin selon la revendication 4 qui est une aube, une ailette ou un segment pour une turbine à gaz.

FIG. 1A      FIG. 1B      FIG. 1C

FIG. 2A      FIG. 2B      FIG. 2C

LARSON-MILLER STRESS-RUPTURE

CMSX-4® ALLOY (001) (WITHOUT DENSITY CORRECTION
vs. RENE' N5 (001)
vs. CMSX®-7 (001)

CMSX-4®      AVERAGE

CM 99% + SOLN AC + 6 HRS/2085 F AC + 20 HRS/1600 F AC
4.8mm DIA GAGE SOLIDS (DL 10s)
1.8mm DIA GAGE SOLIDS (mfb)
3 V-1 HEATS     11 V-3 HEATS (1993)

CMSX-7 MFB •

CMSX-4

CMSX-7®
SOLN AC + DOUBLE AGE (2050°F PRIMARY)
▲ DL-10   10 DATA POINTS
• MFB 7 DATA POINTS .070" DIA
   CM HEAT 5V2424

RENE' N5 ➤

RENE' N-5   AVERAGE

RENE' N-515
WALSTON ET AL (GE)
SUPERALLOYS 1996, SEVEN SPRINGS, PA
TMS 1996 (27-34)
(FULLY HEAT TREATED)

CMSX-7 TEST BARS ▲

STRESS (ksi)

100

10

44   46   48   50   52   54   56   58   60

$P = (T+460)(20+LOG10t) \times 1000$

FIG. 3

LARSON MILLER      STRESS - RUPTURE      CMSX®7 ALLOY (5V0424) vs. CMSX - 2/3® ALLOYS (001)

CMSX®-7   AVERAGE
SOLN. AC + DOUBLE AGE
(2050° F PRIMARY)
○ DL-10   10 DATA POINTS
• MFB   7 DATA POINTS
   .070 " ⌀
   CM HEAT SV0424

CMSX - 2/3®   AVERAGE

98% + SOLN AC +
4 HRS / 1975° F AC +
20 HRS / 1600°F AC
95 DATA POINTS
13 CM INRATS
LIFE RANGE 63 - 1455 HRS
(760°C - 1149°C)

STRESS (ksi)

100
90
80
70
60
50
40
30
20
10

38   40   42   44   46   48   50   52   54   56   58   60

$P = (T+460)(20+LOG_{10}k) \; 10^{-3}$ ⟶

FIG. 4

LARSON-MILLER    STRESS - RUPTURE    CMSX-4® ALLOY MINI - FLATS [(.001) ORIENTATION]
CMSX-7 ALLOY MINI FLATS [(.001) ORIENTATION]

CMSX®7    5V0424
SOLND + DOUBLE AGED
.020" (.508 mm) MINI-FLATS
MFB    • 6 DATA POINTS

CMSX-4®    AVERAGE

99% + SOLN. AC + 6 HRS / 2055°F
AS OF 4 HRS / 1975°F AC + 20 HRS / 1600°F AC
.020" (.508mm) MINI-FLATS
MFB A '4' SMATE
31 DATA POINTS
VF719
VF861

CMSX-4®    V7927
CM 98% + 99% + SOLN. AC
+ 6 HRS / 2085 F AC +
20 HRS / 1600 F AC.
.020" (.508mm) MINI-FLATS
(MFB)  + 17 DATA POINTS

$P = (T+460)(20 + LOG_{10} k) \ 10^{-3}$

FIG. 5

FIG. 6A        FIG. 6B        FIG. 6C

15

FIG. 7A                    FIG. 7B                    FIG. 7C

FIG. 8A                    FIG. 8B                    FIG. 8C

FIG. 9A    FIG. 9B    FIG. 9C

FIG. 10 A    FIG. 10B    FIG. 10C

FIG. 11A    FIG. 11B    FIG. 11C

FIG. 12A      FIG. 12B      FIG. 12C

FIG. 13A      FIG. 13B      FIG. 13C

FIG. 14A      FIG. 14B      FIG. 14C

FIG. 15A    FIG. 15B    FIG. 15C

FIG. 16

FIG. 17

FIG. 18

FIG. 19A          FIG. 19B          FIG. 19C

FIG. 20A          FIG. 20B          FIG. 20C

**REFERENCES CITED IN THE DESCRIPTION**

**Patent documents cited in the description**

- EP 2305848 A